# EUROPÄISCHE PATENTANMELDUNG

(11) **EP 0 898 371 A2**
(43) Veröffentlichungstag der Anmeldung: **24.02.1999**
(21) Anmeldenummer: 98114657.4
(22) Anmeldetag: 04.08.1998
(51) Int. Cl.: H03L 7/06

(54) **Verfahren und Vorrichtung zum Einstellen der Schwingfrequenz eines Oszillators**

(30) Priorität: 21.08.1997 DE 19736463
(71) Anmelder: SIEMENS AKTIENGESELLSCHAFT, 80333 München (DE)
(72) Erfinder: Heinen, Stefan, 47802 Krefeld (DE); Beyer, Stefan, 86415 Mering (DE)

(57) **Zusammenfassung**

Es werden ein Verfahren und eine Vorrichtung zum Einstellen der Schwingfrequenz eines Oszillators unter Verwendung einer Phasenregelschleife auf einen vorbestimmten Sollwert beschrieben, wobei die Phasenregelschleife nach dem Einschwingen des Oszillators im Ansprechen auf einen von einer Steuereinrichtung übertragenen Befehl deaktiviert wird. Das beschriebene Verfahren und die beschriebene Vorrichtung zeichnen sich dadurch aus, daß der Befehl innerhalb einer Zeit übertragen wird, die kürzer ist als die Zeit, nach welcher eine durch die Befehlsübertragung verursachte Verstellung der Schwingfrequenz des Oszillators zu erwarten wäre.

## Beschreibung

Die vorliegende Erfindung betrifft ein Verfahren gemäß dem Oberbegriff des Patentanspruchs 1 und eine Vorrichtung gemäß dem Oberbegriff des Patentanspruchs 7, d.h. ein Verfahren und eine Vorrichtung zum Einstellen der Schwingfrequenz eines Oszillators unter Verwendung einer Phasenregelschleife auf einen vorbestimmten Sollwert, wobei die Phasenregelschleife nach dem Einschwingen des Oszillators im Ansprechen auf einen von einer Steuereinrichtung übertragenen Befehl deaktiviert wird.

Derartige Verfahren bzw. derartige Vorrichtungen kommen beispielsweise, aber bei weitem nicht ausschließlich in einem nach dem DECT-Standard arbeitenden Funksystem zum Einsatz.

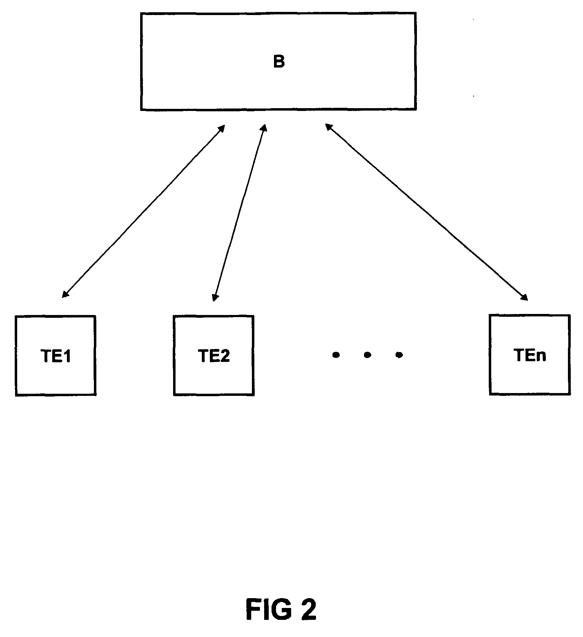

Der prinzipielle Aufbau eines nach dem DECT-Standard arbeitenden Funksystems ist in Figur 2 veranschaulicht.

Das in der Figur 2 gezeigte System besteht aus einer Basisstation B und mehreren schnurlosen Telekommunikationsendeinrichtungen TE1 bis TEn. Die schnurlosen Telekommunikationsendeinrichtungen TE1 bis TEn sind im betrachteten Beispiel Mobiltelefone, welche in der Lage sind, über Funk mit der Basisstation B zu kommunizieren; anstelle der schnurlosen Telekommunikationsendeinrichtungen können auch schnurlose Anschlußdosen zum Anschluß schnurgebundener Telekommunikationsendeinrichtungen zum Einsatz kommen.

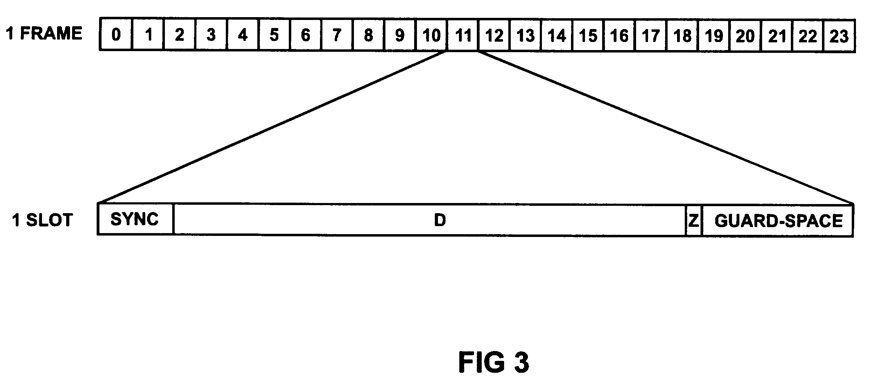

Die Datenübertragung zwischen der Basisstation B und den Mobiltelefonen TE1, TE2, ... TEn (oder anderen Einrichtungen) erfolgt in Einheiten von sogenannten Frames und wird - soweit vorliegend erforderlich - nachfolgend anhand der Figur 3 erläutert. Wie aus der Figur 3 ersichtlich ist, setzt sich ein solcher Frame, genauer gesagt der hier betrachtete DECT-Full-Slot-Frame aus 24 sogenannten Timeslots bzw. Slots (Full-Slots) zusammen. Die ersten 12 der 24 Slots werden von der Basisstation zu den Mobiltelefonen übertragen, und die sich daran anschließenden zweiten 12 Slots werden von den Mobiltelefonen zur Basisstation übertragen. Genauer gesagt werden der nullte Slot eines jedem Frame von der Basisstation zu einem nullten Mobiltelefon, der erste Slot von der Basisstation zu einem ersten Mobiltelefon, der zweite Slot von der Basisstation zu einem zweiten Mobiltelefon, ..., der elfte Slot von der Basisstation zu einem elften Mobiltelefon, und umgekehrt der zwölfte Slot vom nullten Mobiltelefon zur Basisstation, der dreizehnte Slot vom ersten Mobiltelefon zur Basisstation, der vierzehnte Slot vom zweiten Mobiltelefon zur Basisstation, ... und der dreiundzwanzigste Slot vom elften Mobiltelefon zur Basisstation übertragen.

Ein Frame bzw. die 24 Slots eines Frames werden innerhalb von 10 ms übertragen. Jeder Slot umfaßt 480 Bits wird in rund 417 µs (in 416,66 µs) übertragen. Wie aus der Figur 3 ersichtlich ist, verteilen sich die 480 Bis auf ein 32 Bits breites Sync-Feld, ein 388 Bits breites D-Feld, ein 4 Bits breites Z-Feld, und ein 56 Bits breites Guard-Space-Feld.

Für die Übertragung der eigentlich interessierenden Sprachdaten sind 320 Bits innerhalb des D-Feldes reserviert. Die Basisstation kann also innerhalb von 10 ms 320 Bits umfassende Sprachdaten zu jedem der Mobiltelefone versenden und die gleiche Menge an Sprachdaten von jedem der Mobiltelefone empfangen; die Übertragungsrate für Sprachdaten zwischen der Basisstation und jedem der Mobiltelefone beträgt also 32 kBit/s in jede Richtung.

Die Funkfrequenzen, die für den Informations- und Datenaustausch zwischen einer Basisstation B und den Mobiltelefonen TE1 ... TEn verwendet werden, sind aus insgesamt 10 verschiedenen Frequenzen auswählbar; sie werden in Abhängigkeit von den örtlichen Sende- und Empfangsverhältnissen durch die jeweiligen Mobiltelefone bestimmt und können sich aus diesem Grund von Slot zu Slot ändern.

Insbesondere die Basisstation, aber auch die Mobiltelefone, welche im folgenden der Einfachheit halber mit dem Oberbegriff "Funkteile" bezeichnet werden, müssen daher in der Lage sein, die Sende- und Empfangsfrequenz innerhalb kurzer Zeit zu ändern.

Zur Sende- und Empfangsfrequenzumstellung in den Funkteilen eines DECT-Systems gibt es zwei verschiedene Möglichkeiten.

Die eine der Möglichkeiten besteht darin, die Frequenzumstellung während der Dauer des vorstehend bereits erwähnten Guard-Space-Feldes eines jeweiligen Slots durchzuführen. Dies ist möglich, weil im Guard-Space-Feld keine Nutzdaten übertragen werden. Eine solche Frequenzumstellung ist jedoch wegen der Kürze der zur Verfügung stehenden Zeit nur mit einem verhältnismäßig großen Aufwand durchführbar.

Die andere der Möglichkeiten besteht darin, für die Frequenzumstellung jeweils einen eigenen Slot, nämlich einen sogenannten Blind Slot zur Verfügung zu stellen (zu reservieren). Bei dieser Art der Frequenzumstellung wird zwar die maximale Anzahl der an eine Basisstation anschließbaren Mobiltelefone halbiert, doch gestaltet sich die Frequenzumstellung aufgrund der längeren Zeit, die hierfür zur Verfügung steht, erheblich einfacher.

Die Funkteile, in denen von der zuletzt genannten Möglichkeit der Frequenzumstellung Gebrauch gemacht wird, sind sogenannte slow hopping Funkteile und werden im folgenden näher betrachtet.

Um mit verschiedenen Sende- und Empfangsfrequenzen arbeiten zu können, sind die Funkteile vorzugsweise mit Oszillatoren mit veränderbarer Schwingfrequenz ausgestattet. Als Oszillatoren eignen sich insbesondere über eine Phasenregelschleife (PLL) angesteuerte spannungsgesteuerte Oszillatoren (VCO). VCOs und PLLs sind bekannt und bedürfen keiner näheren Beschreibung.

PLLs enthalten bekanntlich einen Phasendetektor, durch den die Phasen einer Referenzschwingung und der Oszillatorschwingung verglichen und ausgewertet werden. Der Phasendetektor gibt ein das Vergleichsergebnis repräsentierendes Signal aus, welches nach einer mehr oder weniger umfangreichen Weiterverarbeitung zur Ansteuerung des VCO verwendet wird und bekanntlich eine sehr genaue Einstellung der Schwingfrequenz des VCO auf einen Sollwert ermöglicht.

Die PLL und der VCO sind bei DECT-Systemen vorzugsweise in einer integrierten Schaltung (IC) untergebracht. Das Ausgangssignal des Phasenkomparators wird in diesem Fall durch eine oder mehrere Ladungspumpen erzeugt.

Die 417 µs eines Blind Slot reichen aus, um die angestrebte Frequenzumstellung durchzuführen. Nachdem der Oszillator auf die neue Frequenz eingeschwungen ist, also spätestens am Ende des betreffenden Blind Slot wird die PLL deaktiviert. Die Deaktivierung wird durch eine in der Regel durch einen Mikrocontroller, Mikroprozessor oder dergleichen gebildete Steuereinrichtung veranlaßt, indem diese einen entsprechenden Befehl überträgt; die Deaktivierung der Phasenregelschleife selbst kann beispielsweise durch ein zumindest teilweises Abschalten der im Phasendetektor enthaltenen Ladungspumpe(n) (durch ein Abschalten der Arbeitspunktversorgung der Ladungspumpen(n), wodurch diese in einen Bereitschafts- bzw. Stand-By-Modus versetzt werden) erfolgen.

Die Erfahrung zeigt, daß es beim Deaktivieren der Phasenregelschleife zu Schwankungen und dauerhaften Verstellungen der Schwingfrequenz des Oszillators kommt, was verständlicher Weise ein Nachteil der bekannten Verfahren und Vorrichtungen ist.

Aus der DE 195 02 111 ist ein Sendeempfänger für Zeitmultiplex-Mehrfachzugriff/Zeitmultiplex-Duplexbetrieb bekannt geworden. Die beschrieben Vorrichtung weist einen Oszillator auf, der von einer abschaltbaren Phasenregelschleife geregelt wird. Das Ein- und Ausschalten der Phasenregelschleife erfolgt dabei durch eine speziell dafür vorgesehene Steuerleitung, was einen entsprechenden Verdrahtungsaufwand nach sich zieht.

T. D. Stetzler, I. G. Post, J. H. Havens und M. Koyama haben in IEEE Journal of Solid-State Circuits, Vol. 30, Nr. 12, Dezember 1995 einen Bericht unter dem Titel 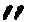 A 2.7 - 4.5 V Single Chip GSM Transceiver RF Integrated Circuit" veröffentlicht, in dem ein von einer Phasenregelschleife geregelter Oszillator als UHF Synthesizer zum Einsatz kommt. Die Programmierung des Synthesizer erfolgt dabei mit Hilfe eines Dreileiterbusses und einem Befehl mit einer Länge von acht Bits.

Der vorliegenden Erfindung liegt daher die Aufgabe zugrunde, das Verfahren gemäß dem Oberbegriff des Patentanspruchs 1 und die Vorrichtung gemäß dem Oberbegriff des Patentanspruchs 3 derart weiterzubilden, daß die Deaktivierung der PLL störungsfrei durchführbar ist.

Diese Aufgabe wird durch ein Verfahren mit den Merkmalen von Patentanspruch 1 bzw. durch eine Vorrichtung mit den Merkmalen von Patentanspruch 3 gelöst.

Demnach ist vorgesehen,
- daß der Befehl zur Deaktivierung der Phasenregelschleife innerhalb einer Zeit übertragen wird, die kürzer ist als die Zeit, nach welcher eine durch die Befehlsübertragung verursachte Verstellung der Schwingfrequenz des Oszillators zu erwarten wäre (kennzeichnender Teil des Patentanspruchs 1) bzw.
- daß eine Phasenregelschleifen-Deaktivierungseinrichtung vorgesehen ist, welche dazu ausgelegt ist, die Phasenregelschleife auf einen Befehl hin zu deaktivieren, dessen Übertragungszeit kürzer ist als die Zeit, nach welcher eine durch die Befehlsübertragung verursachte Verstellung der Schwingfrequenz des Oszillators zu erwarten wäre (kennzeichnender Teil des Patentanspruchs 7).

Bedingt durch die kurze Übertragungszeit des Befehls zur Deaktivierung der Phasenregelschleife kann diese deaktiviert werden, bevor sich die Schwingfrequenz des Oszillators als Reaktion auf die Übertragung des Befehls, wozu auch der Empfang, die Dekodierung und anderweitige Weiterverarbeitungen zählen mögen, verstellen kann.

Im Idealfall kann dadurch erreicht werden, daß die Befehlsübertragung ohne Auswirkungen auf die Schwingfrequenz des Oszillators bleibt.

Gegebenenfalls dennoch durch die Befehlsübertragung verursachte Änderungen der Schwingfrequenz des Oszillators werden erst nach dem Deaktivieren der Phasenregelschleife wirksam und klingen mehr oder weniger schnell vollständig und dauerhaft wieder ab; bei den bislang verwendeten Verfahren und Vorrichtungen kann - wenn überhaupt - allenfalls ein vorübergehendes und/oder teilweises Abklingen der Störungen erfolgen, denn dort wird durch die Phasenregelschleife vor deren Deaktivierung damit begonnen, die Schwingfrequenz des Oszillators nachzuregeln, was nach dem Abklingen der durch die Befehlsübertragung verursachten Störungen eine dauerhafte Verstellung der Schwingfrequenz des Oszillators zur Folge hat.

Die kurze Übertragungszeit des Befehls wird vorzugsweise dadurch erreicht, daß das den Befehl repräsentierende und üblicherweise bitweise seriell übertragene Befehlswort aus nur einigen wenigen Bits besteht.

Alternativ oder zusätzlich kann vorgesehen werden, die Übertragungsgeschwindigkeit, mit welcher die Bitfolge übertragen wird, zu erhöhen.

Es wurden mithin ein Verfahren und eine Vorrichtung gefunden, durch welche eine erforderliche Deaktivierung der Phasenregelschleife auf einfache Weise und ohne gravierende Beeinflussung des Oszillators durchführbar ist.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnung näher erläutert. Es zeigen
- Figur 1: eine schematische Darstellung zur Veranschaulichung der Übertragung von Befehlen über den sogenannten Dreileiterbus,
- Figur 2: den Aufbau eines nach dem DECT-Standard arbeitenden Funksystems, und
- Figur 3: das Format der Daten, die zwischen einer Basisstation und mit dieser kommunizierenden Telekommunikationsendeinrichtungen eines nach dem DECT-Standard arbeitenden Funksystems ausgetauscht werden.

Das erfindungsgemäße Verfahren und die erfindungsgemäße Vorrichtung werden nachfolgend anhand der Sende- und/oder Empfangsfrequenzumstellung in einem nach dem DECT-Standard arbeitenden Funksystem beschrieben. Die Anwendung der Erfindung ist jedoch nicht auf einen derartigen Einsatz beschränkt; sie ist grundsätzlich bei der Einstellung der Schwingfrequenz von in beliebigen Einrichtungen für beliebige Zwecke vorgesehenen Oszillatoren anwendbar.

Der prinzipielle Aufbau des betrachteten DECT-Systems unterscheidet sich - abgesehen von den die Phasenregelschleifen-Deaktivierung betreffenden Details - nicht von dem in der Figur 2 veranschaulichten System.

Auch das in der Figur 3 veranschaulichte Format der Daten, die zwischen einer Basisstation und den an dieser eingebuchten Mobiltelefonen ausgetauscht werden, ist gleich. Der Vollständigkeit halber sei an dieser Stelle jedoch erwähnt, daß es neben den in der Figur 3 gezeigten und unter Bezugnahme darauf beschriebenen sogenannten Full-Slots (480 Bits) auch Half-Slots (240 Bits) und Double-Slots (960 Bits) gibt.

Sämtliche Funkteile des DECT-Systems, d.h. sowohl die Basisstation als auch die Mobiltelefone enthalten zum Erzeugen der Sende- und Empfangsfrequenzen einen Oszillator mit veränderbarer Frequenz.

Der besagte Oszillator ist im betrachteten Beispiel ein zusammen mit einer Phasenregelschleife (PLL) in einer integrierten Schaltung (IC) integrierter spannungsgesteuerter Oszillator (VCO).

Die Phasenregelschleife enthält einen Phasenkomparator, welcher gegebenenfalls vorhandene Phasenverschiebungen zwischen einer (beispielsweise auf die von einem Quarz erzeugte Schwingung zurückgehende) Referenzschwingung und einer (auf die vom VCO erzeugte Schwingung zurückgehende) Oszillatorschwingung ermittelt und ein vom Ausmaß der Phasenverschiebung abhängendes Ausgangssignal erzeugt. Das besagte Ausgangssignal wird mittelbar oder unmittelbar zur Ansteuerung des VCO verwendet, wodurch sich die Frequenz der von diesem erzeugten Schwingung bekanntlich mit sehr hoher Genauigkeit auf einen Sollwert einstellen läßt.

Das Ausgangssignal des Phasenkomparators 1 wird im betrachteten Beispiel, wo der VCO und die PLL Bestandteil einer integrierten Schaltung sind, durch eine oder mehrere Ladungspumpen gebildet. Diese Ladungspumpen werden im betrachteten Beispiel jeweils durch die steigende Flanke der Referenzschwingung aktiviert und durch die steigende Flanke der Oszillatorschwingung in den passiven Zustand zurückversetzt; die Aktivierung und die Deaktivierung kann jedoch auch im Ansprechen auf beliebige andere Flanken der Referenzschwingung und der Oszillatorschwingung erfolgen.

Die Deaktivierung der wie beschrieben aufgebauten und betriebenen Phasenregelschleife erfolgt
- wie bisher durch ein zumindest teilweises Abschalten der im Phasendetektor enthaltenen Ladungspumpen oder
- durch eine Verriegelung der Ladungspumpen-Eingangssignale,
wobei die letztgenannte Möglichkeit vorzuziehen ist, weil sich dadurch die bei der Phasenregelschleifen-Deaktivierung auftretenden Störungen nahezu vollständig zum Verschwinden bringen lassen.

Grundsätzlich kann die Deaktivierung der Phasenregelschleife jedoch auf beliebige Art und Weise erfolgen, d.h. auch durch andere Maßnahmen als die vorstehend erwähnten.

Das Deaktivieren der Phasenregelschleife wird von einer mit dem den Oszillator und die Phasenregelschleife enthaltenden integrierten Schaltkreis in Verbindung stehenden Steuereinrichtung wie einem Mikrocontroller, Mikroprozessor oder dergleichen befohlen. Der Befehl, durch den dies geschieht, ist ein aus mehreren Bits bestehendes Datenwort, das bitweise seriell über den sogenannten Dreileiterbus übertragen wird.

Der besagte Dreileiterbus ist die Schnittstelle, über die ein den Oszillator und/oder die Phasenregelschleife enthaltender integrierter Schaltkreis von einer örtlich getrennt davon (beispielsweise auf einem separaten integrierten Schaltkreis) vorgesehenen Steuereinrichtung normalerweise angesteuert wird; er stellt die in solchen Fällen üblicherweise zum Einsatz kommende Inter-Chip-Schnittstelle dar.

Der Dreileiterbus umfaßt, wie die Bezeichnung schon andeutet, drei Leitungen, nämlich eine Enable-Leitung, eine Takt-Leitung und eine Daten-Leitung.

Die über den Dreileiterbus übertragbaren Befehle sind, wie vorstehend bereits erwähnt wurde, aus mehreren Bits bestehende Datenworte, die bitweise seriell übertragen werden.

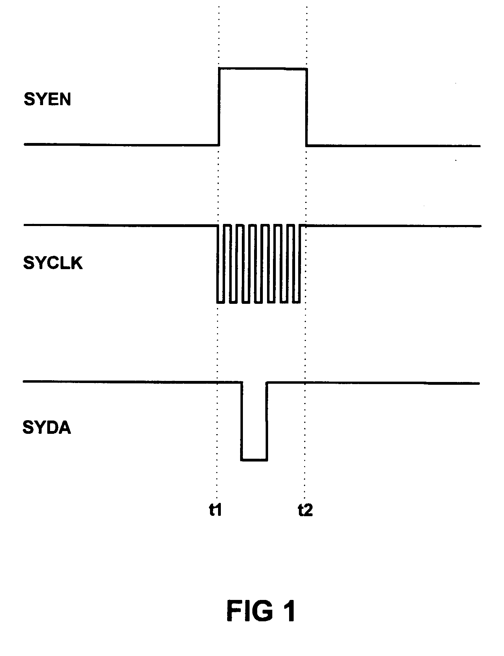

Die Übertragung eines Befehls über den Dreileiterbus ist in Figur 1 schematisch veranschaulicht. Gemäß der Darstellung in der Figur 1 wird vom Zeitpunkt t1 bis zum Zeitpunkt t2 ein Befehl übertragen. Vor dem Zeitpunkt t1 und nach dem Zeitpunkt t2 befinden sich die mit SYEN bezeichnete Enable-Leitung, die mit SYCLK bezeichneten Takt-Leitung und die mit SYDA bezeichnete Daten-Leitung im Ruhezustand. Dieser Ruhezustand wird unterbrochen, wenn und so lange ein Befehl zu übertragen ist. Der Beginn und das Ende der Übertragung eines oder mehrerer Befehle wird durch die Enable-Leitung signalisiert; diese geht mehr oder weniger kurz vor dem Beginn der Übertragung in den aktiven Zustand und behält diesen bis mehr oder weniger kurz nach dem Ende der Übertragung bei. Wenn und so lange die Enable-Leitung aktiv ist, können über die Daten-Leitung SYDAT in dem über die Takt-Leitung SYCLK mitübertragenen Takt sequentiell die Bits des oder der zu übertragenden Datenworte übertragen werden.

Der Dreileiterbus wird "nur" unidirektional betrieben. D.h. es werden ausschließlich Daten von der Steuereinrichtung zum Oszillator und/oder zur Phasenregelschleife übertragen; der Oszillator und/oder die Phasenregelschleife quittieren nicht einmal den Empfang der Daten.

Die wie beschrieben über den Dreileiterbus zum Oszillator und/oder zur Phasenregelschleife übertragenen Daten können verschiedene Befehle repräsentieren. Durch diese Befehle wird unter anderem eine Initialisierung des Oszillators und/oder der Phasenregelschleife durchgeführt, die Sollfrequenz der vom Oszillator zu erzeugenden Schwingung übermittelt, und schließlich auch die vorliegend näher betrachtete Deaktivierung der Phasenregelschleife veranlaßt.

Die Deaktivierung der Phasenregelschleife läßt sich störungsfrei oder zumindest störungsarm durchführen, wenn der entsprechende Befehl so kurz ist, bzw. aus so wenigen Bits besteht, daß er in minimal kurzer Zeit übertragbar, dekodierbar und ausführbar ist. Dann ist nämlich keine oder jedenfalls fast keine Zeit und Möglichkeit vorhanden, daß sich die Schwingfrequenz des Oszillators vor der Phasenregelschleifen-Deaktivierung im Ansprechen auf die Übertragung, den Empfang, die Auswertung und die Ausführung des entsprechenden Befehls verstellt.

Derartige Verstellungen der Schwingfrequenz können aufgrund kapazitiver und induktiver Kopplungen, lokaler Veränderungen der Chiptemperatur, dadurch und/oder durch Schaltvorgänge verursachte Versorgungsspannungsschwankungen und dergleichen auftreten, welche bei der Aktivierung von normalerweise passiven Schaltungsteilen nahezu unvermeidlich sind.

Im betrachteten Beispiel wird der Befehl zur Deaktivierung der Phasenregelschleife durch ein aus drei Bits bestehendes Datenwort repräsentiert. Es weist damit nur einen kleinen Bruchteil der Länge des Datenwortes auf, das bisher zum Befehlen der Deaktivierung der Phasenregelschleife versandt wird. Bislang wird nämlich ein aus über 20 Bits bestehendes Datenwort verwendet.

Die außerordentlich umfangreiche Verkürzung des Datenwortes zum Befehlen der Deaktivierung der Phasenregelschleife ermöglicht es, dieses bei ansonsten unveränderten Bedingungen in erheblich kürzerer Zeit zu übertragen als dies bisher möglich ist. Der Befehl kann dadurch - gerechnet vom Beginn der Übertragung des Befehlswortes an - so früh ausgeführt werden, daß die zuvor genannten nachteiligen Erscheinungen (kapazitive und induktive Kopplungen, lokale Veränderungen der Chiptemperatur, dadurch und/oder durch Schaltvorgänge verursachte Versorgungsspannungsschwankungen etc.) ausbleiben oder jedenfalls noch keine oder wenigstens keine nennenswerte Wirkung zeigen.

Die drei Bits, aus denen das Datenwort zum Befehlen der Deaktivierung der Phasenregelschleife besteht, stellen noch nicht die untere Grenze der theoretisch realisierbaren Datenwort-Länge dar. Die Datenwort-Länge wurde jedoch gleichwohl so festgelegt, weil aufgrund der dadurch geschaffenen Redundanz Übertragungsfehler bei der Befehlsübertragung erkannt und/oder gegebenenfalls sogar korrigiert werden können.

Alternativ oder zusätzlich kann vorgesehen werden, die Übertragungszeit zu verkürzen, indem die Übertragungsgeschwindigkeit gesteigert wird bzw. - anders ausgedrückt - die einzelnen Bits eines jeweiligen Datenwortes in schnellerer Aufeinanderfolge übertragen werden. Dies ist grundsätzlich problemlos möglich, weil der Übertragungstakt über die Takt-Leitung SYCLK des Dreileiterbusses mitübertragen wird. Der Einsatz dieser Maßnahme kann gegebenenfalls auf den Befehl zur Deaktivierung der Phasenregelschleife und ähnlich problematisch handhabbare Befehle beschränkt werden.

Die Steigerung der Übertragungsgeschwindigkeit zeigt im Ergebnis die selbe Wirkung wie die Verkürzung des Befehls-Datenwortes. D.h., auch hier können die davon betroffenen Befehle so früh ausgeführt werden, daß die zuvor genannten nachteiligen Erscheinungen (kapazitive und induktive Kopplungen, lokale Veränderungen der Chiptemperatur, dadurch und/oder durch Schaltvorgänge verursachte Versorgungsspannungsschwankungen etc.) ausbleiben oder jedenfalls noch keine oder wenigstens keine nennenswerte Wirkung zeigen.

Zusammenfassend und verallgemeinernd kann festgestellt werden, daß sich die Deaktivierung der Phasenregelschleife mit erheblich weniger oder gänzlich ohne Störungen durchführen läßt, wenn
- der Befehl zur Deaktivierung der Phasenregelschleife innerhalb einer Zeit übertragen wird, die kürzer ist als die Zeit, nach welcher eine durch die Befehlsübertragung verursachte Verstellung der Schwingfrequenz des Oszillators zu erwarten wäre bzw.
- eine zur Deaktivierung der Phasenregelschleife vorgesehene Phasenregelschleifen-Deaktivierungseinrichtung dazu ausgelegt ist, die Phasenregelschleife auf einen Befehl hin zu deaktivieren, dessen Übertragungszeit kürzer ist als die Zeit, nach welcher eine durch die Befehlsübertragung verursachte Verstellung der Schwingfrequenz des Oszillators zu erwarten wäre.

Die beschriebenen Verfahren und Vorrichtungen sind den herkömmlichen Verfahren und Vorrichtungen trotz der nur geringfügig und einfach vorzunehmenden Modifikationen deutlich überlegen. Die Schwingfrequenz des Oszillators kann dadurch innerhalb kürzester Zeit exakt und dauerhaft auf dessen Sollwert eingestellt werden.

### Bezugszeichenliste

- B: Basisstation
- TE1 ... TEn: Telekommunikationsendeinrichtungen
- SYEN: Enable-Leitung
- SYCLK: Takt-Leitung
- SYDA: Daten-Leitung

## Patentansprüche

1. Verfahren zum Einstellen der Schwingfrequenz eines Oszillators unter Verwendung einer Phasenregelschleife auf einen vorbestimmten Sollwert, wobei die Phasenregelschleife nach dem Einschwingen des Oszillators im Ansprechen auf einen von einer Steuereinrichtung übertragenen Befehl deaktiviert wird, wobei die Übertragung des Befehls von der Steuereinrichtung zum Oszillator und/oder zur Phasenregelschleife über einen für serielle Datenübertragungen ausgelegten Bus (SYEN, SYCLK, SYDA) erfolgt,
**dadurch gekennzeichnet**,
daß als Befehl ein aus drei Bits bestehendes Datenwort verwendet wird.

2. Verfahren nach Patentanspruch 1,
**dadurch gekennzeichnet**,
daß durch das Einstellen der Schwingfrequenz des Oszillators eine Sende- oder Empfangsfrequenzumstellung in einem zu einem nach dem DECT-Standard arbeitenden Funkteil (B, TE1, TE2, ... TEn) erfolgt.

3. Vorrichtung zum Einstellen der Schwingfrequenz eines Oszillators unter Verwendung einer Phasenregelschleife auf einen vorbestimmten Sollwert, wobei der Oszillator und/oder die Phasenregelschleife über einen für bitweise serielle Datenübertragungen ausgelegten Bus mit einer Steuereinrichtung verbunden sind und wobei die Phasenregelschleife nach dem Einschwingen des Oszillators im Ansprechen auf einen von der Steuereinrichtung übertragenen Befehl deaktiviert wird,
**dadurch gekennzeichnet daß,**
der Befehl zum Deaktivieren der Phasenregelschleife drei Bits aufweist.
